(19) **Europäisches Patentamt European Patent Office Office européen des brevets**

(11) **EP 4 546 312 A1**

(12) **EUROPEAN PATENT APPLICATION**
published in accordance with Art. 153(4) EPC

(43) Date of publication:
**30.04.2025 Bulletin 2025/18**

(21) Application number: **23850268.6**

(22) Date of filing: **05.07.2023**

(51) International Patent Classification (IPC):
*G09F 9/30* (2006.01)     *G06F 1/16* (2006.01)
*H04M 1/02* (2006.01)     *G09F 9/33* (2006.01)

(52) Cooperative Patent Classification (CPC):
**G06F 1/16; G09F 9/30; G09F 9/33; H04M 1/02**

(86) International application number:
**PCT/KR2023/009503**

(87) International publication number:
**WO 2024/029759 (08.02.2024 Gazette 2024/06)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **02.08.2022 KR 20220096233**
              **01.09.2022 KR 20220110911**

(71) Applicant: **Samsung Electronics Co., Ltd.**
**Suwon-si, Gyeonggi-do 16677 (KR)**

(72) Inventors:
• **CHO, Hyunmoon**
  **Suwon-si Gyeonggi-do 16677 (KR)**
• **PARK, Jinhyun**
  **Suwon-si Gyeonggi-do 16677 (KR)**
• **OH, Seungtaek**
  **Suwon-si Gyeonggi-do 16677 (KR)**
• **LIM, Sunghwan**
  **Suwon-si Gyeonggi-do 16677 (KR)**

(74) Representative: **Gulde & Partner**
**Patent- und Rechtsanwaltskanzlei mbB**
**Berliner Freiheit 2**
**10785 Berlin (DE)**

(54) **ELECTRONIC APPARATUS COMPRISING FLEXIBLE DISPLAY**

(57)     An electronic apparatus according to one embodiment of the present disclosure may comprise: a first housing; a second housing that rotates or slides relative to the first housing; and a flexible display which folds or unfolds on the basis of the relative movement of the second housing, and which includes a first display area, a second display area, and a folding area for connecting the first display area to the second display area. The flexible display can comprise: a protective layer; a first adhesive layer which is disposed beneath the protective layer, and which includes a first adhesive part that is located in the folding area and a second adhesive part that encompasses side surfaces of the first adhesive part; a second adhesive layer which is disposed beneath the first adhesive layer, and which includes a third adhesive part that is located in each of the first display area and the second display area adjacent to the folding area and a fourth adhesive part that encompasses side surfaces of the third adhesive part; and a display panel disposed beneath the second adhesive layer.

FIG. 5

EP 4 546 312 A1

**Description**

[Technical Field]

The disclosure relates to an electronic device including a flexible display.

[Background Art]

Due to advancement in information and communication technology and semiconductor technology, various functions are being integrated into a single portable electronic device. For example, an electronic device may implement not only communication functions, but also entertainment functions such as gaming, multimedia functions such as music/video playback, communication and security functions for mobile banking or the like, and functions for schedule management and an electronic wallet function. These electronic devices are being miniaturized to be conveniently carried by users.

As mobile communication service extends into the multimedia service domain, it is necessary to increase the display sizes of electronic devices in order to allow users to fully utilize multimedia services, as well as voice calls and short message services. However, the display sizes of electronic devices are in a trade-off relationship with the miniaturization of electronic devices.

[Detailed Description of the Invention]

[Technical Solution]

According to an embodiment of the disclosure, an electronic device may include a first housing, a second housing configured to rotate or slide relative to the first housing, and a flexible display configured to be unfolded or bent based on relative movement of the second housing and including a first display area, a second display area, and a folding area connecting the first display area and the second display area. The flexible display may include a protective layer, a first adhesive layer disposed beneath the protective layer and including a first adhesive portion disposed in the folding area, and a second adhesive portion provided to enclose the side surface of the first adhesive portion, a second adhesive layer disposed beneath the first adhesive layer including a third adhesive portion disposed in each of the first and second display areas, which are adjacent to the folding area, and a fourth adhesive portion provided to enclose the side surfaces of the third adhesive portion, and a display panel disposed beneath the second adhesive layer.

According to an embodiment of the disclosure, a method of manufacturing a flexible display may include a process of cutting a protective layer and a glass layer to correspond to the size of a display panel, a process of increasing temperature to bond a first adhesive layer to the protective layer, a process of applying or coating the first adhesive layer, which is divided into a first adhesive portion and a second adhesive portion having different Young's moduli, onto the lower surface of the protective layer, a process of bonding the glass layer to the lower surface of the first adhesive layer, a process of applying or coating the second adhesive layer, which is divided into a third adhesive portion and a fourth adhesive portion having different Young's moduli, onto the lower surface of the glass layer, and a process of lowering the increased temperature to room temperature.

However, the problems that the disclosure seeks to solve are not limited to the aforementioned problems, and may be expanded in various ways without departing from the spirit and scope of the disclosure.

[Brief Description of Drawings]

FIG. 1 is a block diagram of an electronic device according to an embodiment of the disclosure in a network environment.
FIG. 2 is a view illustrating an electronic device according to an embodiment of the disclosure in an unfolded state.
FIG. 3 is a view illustrating the electronic device according to an embodiment of the disclosure in a folded state.
FIG. 4 is an exploded perspective view of an electronic device according to an embodiment of the disclosure.
FIG. 5 is a cross-sectional view illustrating a folding area and a surrounding area of a flexible display according to an embodiment of the disclosure.
FIG. 6 is a view illustrating a portion of a first adhesive layer of the flexible display according to an embodiment of the disclosure.
FIG. 7 is a view illustrating a portion of a second adhesive layer of the flexible display according to an embodiment of the disclosure.

FIG. 8A is a schematic view illustrating a part of the process for laminating a flexible display according to an embodiment of the disclosure.

FIG. 8B is a schematic view illustrating another part of the process for laminating a flexible display according to an embodiment of the disclosure.

FIG. 8C is a schematic view illustrating yet another part of the process for laminating a flexible display according to an embodiment of the disclosure.

FIG. 9 is a flowchart illustrating the process for laminating a flexible display according to an embodiment of the disclosure.

[Mode for Carrying out the Invention]

The electronic devices according to the embodiments disclosed herein may be any of various types of devices. The electronic device may include, for example, a portable communication device (e.g., a smartphone), a computer device, a portable multimedia device, a portable medical device, a camera, a wearable device, or a home appliance. The electronic devices according to the embodiments disclosed herein are not limited to the above-described devices.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

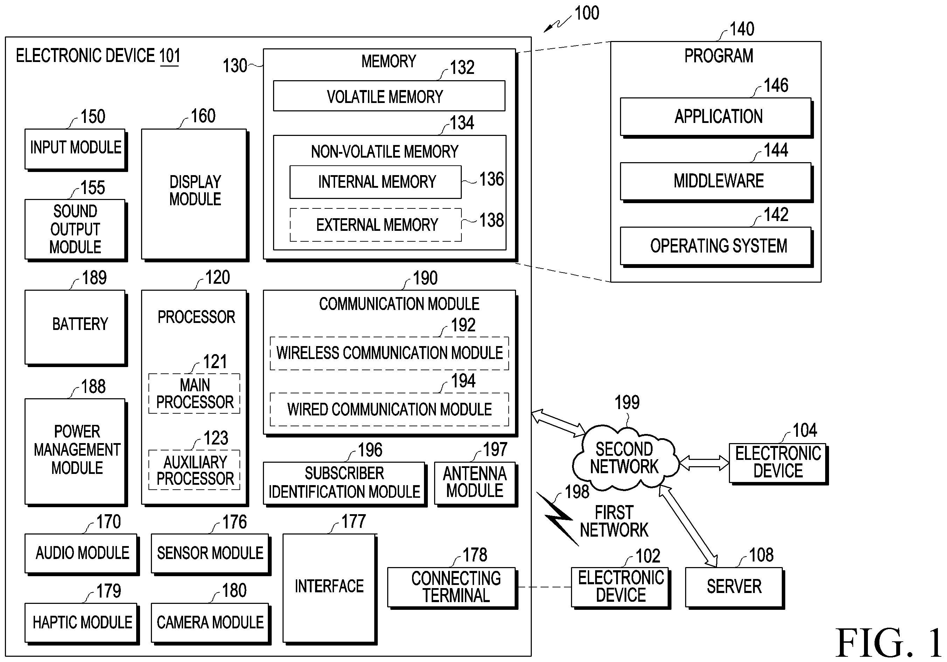

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth™, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

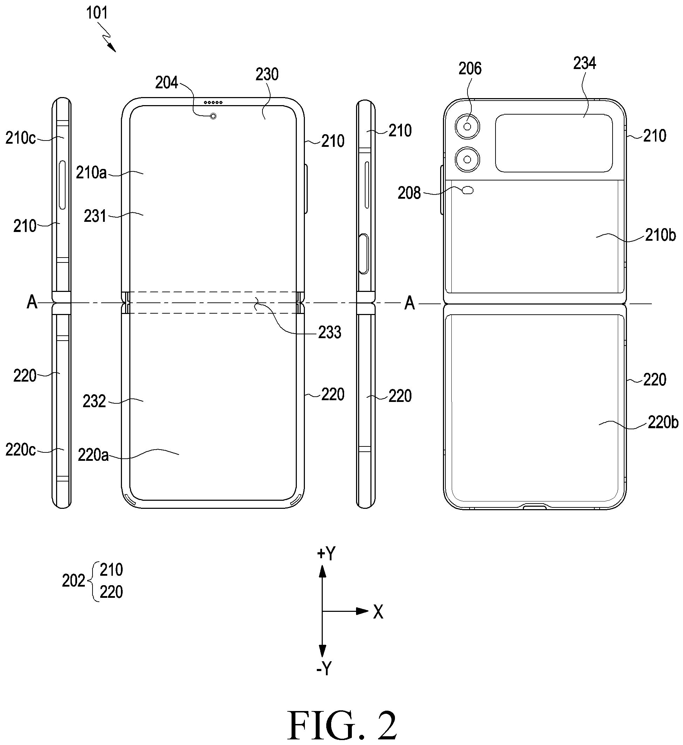

FIG. 2 is a view illustrating an electronic device according to an embodiment of the disclosure in an unfolded state.

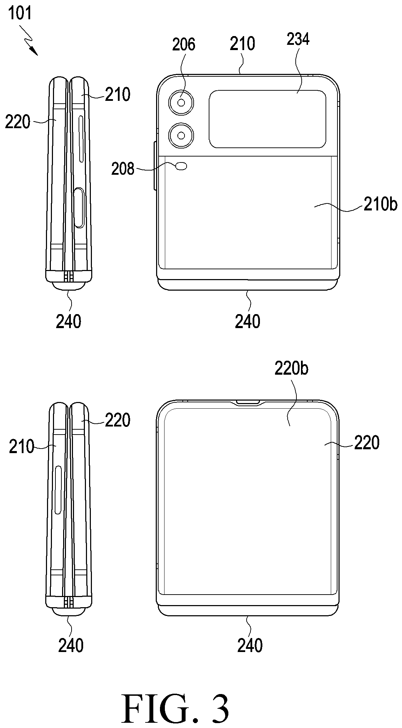

FIG. 3 is a view illustrating the electronic device according to an embodiment of the disclosure in a folded state.

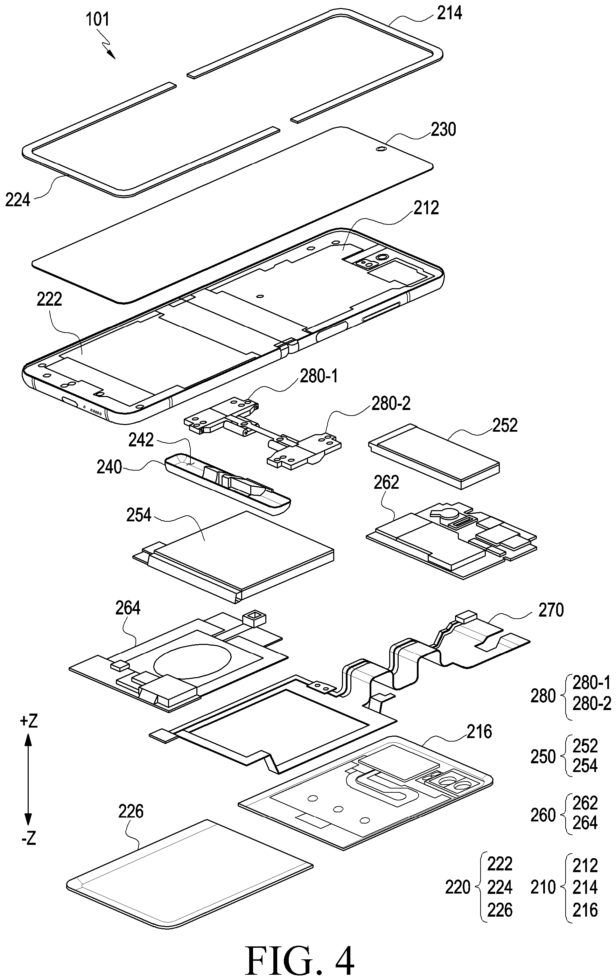

Referring to FIGS. 2 and 3, the electronic device 101 may include a housing 202 configured to accommodate components of the electronic device 101 (e.g., the battery 250 and/or the circuit board 260 in FIG. 4) and a flexible display or foldable display 230 (hereinafter, referred to as a "display 230") connected to the housing 202. According to an embodiment, the housing 202 may be referred to as a "foldable housing".

According to an embodiment, the housing 202 may include a first housing 210 and a second housing 220 configured to relatively rotate with respect to the first housing 210.

According to an embodiment, the first housing 210 and/or the second housing 220 may define at least a part of the exterior of the electronic device 101. According to an embodiment, the surface on which the display 230 is visually exposed is defined as the front surface (e.g., a first front surface 210a and a second front surface 220a) of the electronic device 101 and/or the housing 202. The surface opposite to the front surface is defined as the rear surface (e.g., a first rear surface 210b and a second rear surface 220b) of the electronic device 101. The surface surrounding at least a portion of the space between the front and rear surfaces is defined as the side surface (e.g., a first side surface 210c and a second side surface 220c) of the electronic device 101.

According to an embodiment, the first housing 210 may be rotatably connected to the second housing 220. For example, the first housing 210 may be rotatably connected to the second housing 220 using a hinge structure (e.g., the hinge structure 280 in FIG. 4). The electronic device 101 may be switched to a folded state (e.g., FIG. 2) or an unfolded state (e.g., FIG. 3). When the electronic device 101 is in the folded state, the first front surface 210a may face the second front surface 220a, and when the electronic device 200 is in the unfolded state, the direction where the first front surface 210a is oriented may be the same as the direction where the second front surface 220a is oriented. For example, in the unfolded state, the first front surface 210a may be disposed on substantially the same plane as the second front surface 220a. According to an embodiment, the second housing 220 may move relative to the first housing 210. According to an embodiment, the first housing 210 may receive force to rotate relative to the second housing 220 using an elastic member (not illustrated).

According to an embodiment, the first housing 210 and the second housing 220 may be disposed on opposite sides about the folding axis A and may have generally symmetrical shapes with respect to the folding axis A. The angle between the first housing 210 and the second housing 220 may change depending on whether the electronic device 101 is in the unfolded state, the folded state, or an intermediate state between the unfolded state and the folded state.

According to an embodiment, the electronic device 101 may include a hinge cover 240. At least a portion of the hinge cover 240 may be disposed between the first housing 210 and the second housing 220. According to an embodiment, depending on the state of the electronic device 101, the hinge cover 240 may be covered by portions of the first housing 210 and the second housing 220 or may be exposed to the outside of the electronic device 101. According to an embodiment, the hinge cover 240 may protect the hinge structure (e.g., the hinge structure 280 in FIG. 4) from external impact of the electronic device 101. According to an embodiment, the hinge cover 240 may be referred to as a "hinge housing".

According to an embodiment, as illustrated in FIG. 2, when the electronic device 101 is in the unfolded state, the hinge cover 240 may not be exposed by being covered by the first housing 210 and the second housing 220. In an embodiment, as illustrated in FIG. 3, when the electronic device 101 is in the folded state (e.g., the fully folded state), the hinge cover 240 may be exposed to the outside in the space between the first housing 210 and the second housing 220. In an embodiment, when the first housing 210 and the second housing 220 are in the intermediate state in which the first and second housings are folded with a certain angle therebetween, the hinge cover 240 may be partially exposed to the outside between the first housing 210 and the second housing 220. However, the area exposed in this case may be smaller than that in the fully folded state. According to an embodiment, the hinge cover 240 may include a curved surface.

According to an embodiment, the display 230 may visually provide information to the outside of the electronic device 101 (e.g., a user). The display 230 may include, for example, a hologram device or a projector, and a control circuit to control the corresponding device. According to an embodiment, the display 230 may include a touch sensor configured to detect a touch or a pressure sensor configured to measure the intensity of force generated by the touch.

According to an embodiment, the display 230 may refer to a display, at least a portion of which is transformable into a planar surface or a curved surface. For example, the display 230 may be configured to vary in response to the relative movement of the second housing 220 with respect to the first housing 210. According to an embodiment, the display 230 may include a folding area 233, and a first display area 231 disposed on one side (e.g., above (in the +Y direction)) of the folding area 233 and a second display area 232 disposed on the other side (e.g., below (in the -Y direction)) with respect to the folding area 233. According to an embodiment, the folding area 233 may be disposed above a hinge structure (e.g., the hinge structure 280 in FIG. 4) when the electronic device 101 is in the unfolded state (e.g., FIG. 2). For example, at least a portion of the folding area 233 may face the hinge structure 280. According to an embodiment, the folding area 233 may be referred to as a portion of the display 230 that bends at least partially based on a change in the state of the electronic device 101 (e.g., folded or unfolded). According to an embodiment, the first display area 231 may be disposed on the first housing 210, and the second display area 232 may be disposed on the second housing 220. According to an embodiment, the display 230 may be accommodated in the first housing 210 and the second housing 220.

However, the area division of the display 230 illustrated in FIG. 2 is exemplary, and the display 230 may be divided into multiple (e.g., four or more or two) areas depending on its structure or function.

In addition, in the embodiment illustrated in FIG. 1, the areas of the display 230 may be divided by the folding area 233 or the folding axis (the axis A) extending in parallel to the X-axis. However, in an embodiment, the areas of the display 230 may be divided with reference to another folding area (e.g., a folding area parallel to the Y-axis) or another folding axis (e.g., a folding axis parallel to the Y-axis). According to an embodiment, the display 230 may be coupled to or disposed adjacent to a touch detection circuit, a pressure sensor that is capable of measuring touch intensity (pressure), and/or a digitizer configured to detect a magnetic field-type stylus pen.

According to an embodiment, the electronic device 101 may include a rear surface display 234. The rear surface display 234 may be disposed to be facing a different direction from the display 230. For example, the display 230 may be visually exposed through the front surface (e.g., the first front surface 210a and/or the second front surface 220a) of the electronic device 101, and the rear surface display 234 may be visually exposed through the rear surface (e.g., the first rear surface 210b) of the electronic device 101.

According to an embodiment, the electronic device 101 may include one or more camera modules 204 and 206 and a flash 208. According to an embodiment, the electronic device 101 may include a front camera module 204 exposed through the front surface (e.g., the first front surface 210a) and/or a rear camera module 206 exposed through the rear surface (e.g., the first rear surface 210b). The camera modules 204 and 206 may include one or more lenses, image sensors, flashes, and/or image signal processors. The flash 208 may include a light-emitting diode or xenon lamp. In some embodiments, two or more lenses (e.g., an infrared camera, a wide-angle lens, and a telephoto lens), and image sensors may be arranged on one surface of the electronic device 101. The front camera module 204 and/or the rear camera module 206 may capture still images and videos. According to an embodiment, the camera modules 204 and 206 may include one or more lenses, image sensors, image signal processors, or flashes.

FIG. 4 is an exploded perspective view of an electronic device according to an embodiment of the disclosure.

Referring to FIG. 4, the electronic device 101 may include a first housing 210, a second housing 220, a display 230, a hinge cover 240, a battery 250, a printed circuit board 260, a flexible printed circuit board 270, and a hinge structure 280. The configurations of the first housing 210, the second housing 220, the display 230, and the hinge cover 240 of FIGS. 2 and 3 may be entirely or partially identical to those of the first housing 210, the second housing 210, the display 230, and the hinge cover 240 of FIG. 1 and/or FIG. 2. The structures in FIG. 4 may be selectively combined with the structures in FIGS. 2 and 3.

According to an embodiment, the electronic device 101 may include a first support member 212 and a second support member 222. For example, the first housing 210 may include a first support member 212, and the second housing 220 may include a second support member 222. According to an embodiment, the first support member 212 and/or the second support member 222 may support components of the electronic device 101 (e.g., the display 230, the battery 250, and the printed circuit board 260).

According to an embodiment, the first support member 212 and/or the second support member 222 may be made of a metal material and/or a non-metal (e.g., polymer) material. According to an embodiment, the first support member 212 may be disposed between the display 230 and the battery 250. For example, the display 230 may be coupled to one surface of the first support member 212, and the battery 250 and the printed circuit board 260 may be disposed on the other surface.

According to an embodiment, the electronic device 101 may include a first protective member 214 and a second protective member 224. For example, the first housing 210 may include the first protective member 214, and the second housing 220 may include the second protective member 224. According to an embodiment, the protective members 214 and 224 may protect the display 230 from external impacts. For example, the first protective member 214 may surround at least a portion of the display 230 (e.g., the first display area 231 in FIG. 2), and the second protective member 224 may surround at least a portion of another portion of the display 230 (e.g., the second display area 232 in FIG. 2). According to an embodiment, the first protective member 214 may be referred to as a first decoration member, and the second protective member 224 may be referred to as a second decoration member.

According to an embodiment, the housings 210 and 220 may include a first rear surface plate 216 and a second rear surface plate 226. For example, the first housing 210 may include the first rear surface plate 216 connected to the first support member 212, and the second housing 220 may include the second rear surface plate 226 connected to the second support member 222. According to an embodiment, the rear surface plates 216 and 226 may define a portion of the exterior of the electronic device 101. For example, the first rear surface plate 216 may define the first rear surface (e.g., the first rear surface 210b in FIG. 1), and the second rear surface plate 226 may define the second rear surface (e.g., the second rear surface 220b in FIG. 1). According to an embodiment, a first battery 252 and a first printed circuit board 262 may be disposed between the first support member 212 and the first rear surface plate 216, and a second battery 254 and a second printed circuit board 264 may be disposed between the second support member 222 and the second rear surface plate 226.

According to an embodiment, the hinge cover 240 may accommodate at least a portion of the hinge structure 280. For example, the hinge cover 240 may include an accommodation groove 242 to accommodate the hinge structure 280. According to an embodiment, the hinge cover 240 may be coupled with the hinge structure 280. According to an embodiment, when the electronic device 101 is in the unfolded state, at least a portion of the hinge cover 240 may be disposed between the hinge structure 280 and the housings 210 and 220. According to an embodiment, the hinge cover 240 can guide the movement of the housings 210 and 220. For example, the first housing 210 and the second housing 220 may rotate relative to the hinge cover 240 in the state of being connected to the hinge cover 240.

According to an embodiment, the battery 250 is a device that supplies power to at least one component of the electronic device 101, and may include a non-rechargeable primary battery, a rechargeable secondary battery, or a fuel cell. The battery 250 may be integrally disposed inside the electronic device 101 or may be detachably disposed on the electronic device 101. According to an embodiment, the battery 250 may include a first battery 252 disposed in the first housing 210 and a second battery 254 disposed in the second housing 220. For example, the first battery 252 may be disposed on the first support member 212, and the second battery 254 may be disposed on the second support member 222.

According to an embodiment, the printed circuit board 260 may be mounted with a processor, memory, and/or an interface. According to an embodiment, the printed circuit board 260 may include a first printed circuit board 262 disposed in the first housing 210 and a second printed circuit board 264 disposed in the second housing 220.

According to an embodiment, the flexible printed circuit board 270 may electrically connect a component disposed in the first housing 210 (e.g., the first printed circuit board 262) and a component disposed in the second housing 220 (e.g., the second printed circuit board 264). According to an embodiment, at least a portion of the flexible printed circuit board 270 may cross the hinge cover 240 and/or the hinge structure 280. For example, a portion of the flexible printed circuit board 270 may be disposed within the first housing 210 and another portion may be disposed within the second housing 220. According to an embodiment, the flexible printed circuit board 270 may include a first flexible printed circuit board 272 connected to an antenna and a second flexible printed circuit board 274 connected to the display 230.

According to an embodiment, the hinge structure 280 may include multiple hinge structures 280-1 and 280-2 arranged in parallel to each other. For example, the hinge structure 280 may include a first hinge structure 280-1 and a second hinge structure 280-2 spaced apart from the first hinge structure 280-1. According to an embodiment, the first hinge structure 280-1 and the second hinge structure 280-2 may be symmetrical to each other with respect to the length direction of the electronic device 101 (e.g., the Y-axis direction).

According to an embodiment, FIGS. 2 to 4 illustrate the electronic device as a foldable electronic device of a flip-type capable of in-folding, but the disclosure is not limited thereto. For example, the electronic device may include various electronic devices including a flexible display in which a portion of the display area (e.g., a folding area) is bendable or rollable, such as a foldable electronic device capable of out-folding, a multi-foldable electronic device capable of in-folding and out-folding multiple times, or an electronic device including a display capable of expanding through sliding movement between housings.

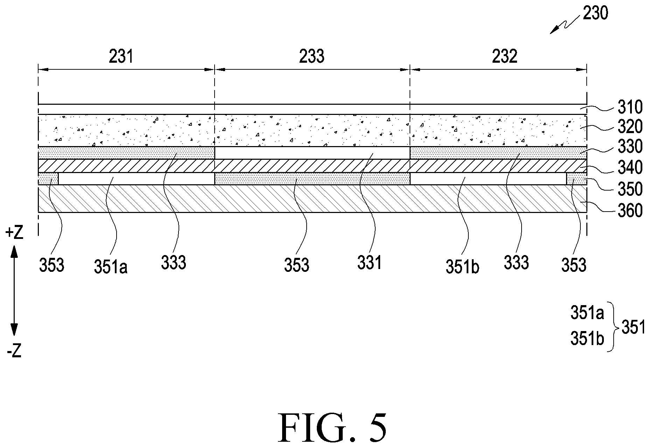

FIG. 5 is a cross-sectional view illustrating a folding area and a surrounding area of a flexible display according to an embodiment disclosed herein.

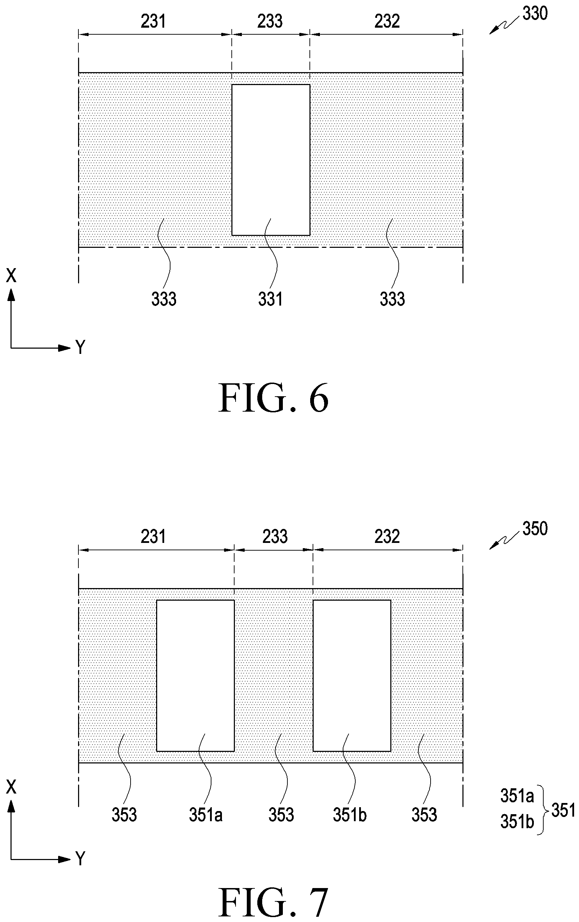

FIG. 6 is a view illustrating a portion of a first adhesive layer of a flexible display according to an embodiment disclosed herein.

FIG. 7 is a view illustrating a portion of a second adhesive layer of a flexible display according to an embodiment disclosed herein.

**In** an embodiment, the electronic device 101 may include a first housing (e.g., the first housing 210 in FIG. 2), a second housing (e.g., the second housing 220 in FIG. 2), and a display 230 (hereinafter, the flexible display 230). The configuration of the flexible display of FIGS. 5 to 7 may be wholly or partially identical to the configuration of the display 230 of FIGS. 1 to 4. The structures of FIGS. 5, 6, and 7 may be optionally combined with the structures of FIGS. 2 to 4.

According to an embodiment, the flexible display 230 may be configured to be unfolded or folded (e.g., bent or rolled) based on relative movement of the first housing or the second housing, and may include a first display area 231 connected to the first housing, a second display area 232 connected to the second housing, and a folding area 233 connecting the first display area 231 and the second display area 232.

According to an embodiment, the flexible display 230 may include a display panel 360 and multiple films laminated for the display panel 360. The multiple films may include, based on the coating layer 310 exposed to the outside, a protective layer 320, a first adhesive layer 330, a glass layer 340, and a second adhesive layer 350 arranged toward the display panel 360. As illustrated in FIG. 5, the coating layer 310, the protective layer 320, the first adhesive layer 330, the glass layer 340, and the second adhesive layer 350 may be sequentially laminated. However, the disclosure is not limited thereto, and additional films may be arranged in addition to the coating layer 310, the protective layer 320, the first adhesive layer 330, the glass layer 340, and the second adhesive layer 350, or some of these layers may be omitted. As another example, the order of the coating layer 310, the protective layer 320, the first adhesive layer 330, the glass layer 340, and the second adhesive layer 350 may be disposed differently depending on design conditions.

According to an embodiment, the coating layer 310 may be disposed as the outermost coating layer of the flexible display 230 and may be arranged across the first display area 231, the folding area 233, and the second display area 232 of the flexible display 230. A portion of the coating layer 310 disposed in the folding area 233 may be bent and/or rolled in response to the bending and/or rolling of the flexible display 230. According to an embodiment, the coating layer 310 may protect the flexible display from external impact. The coating layer may be made of a hard material or may be made of a material capable of limiting or reducing a user's fingerprint. For example, the coating layer 310 may include a hard coating layer and/or an anti-fingerprint coating layer.

According to an embodiment, the protective layer 320 may be disposed beneath the coating layer 310 and may be made of a soft material. For example, the protective layer 320 may be disposed in full contact with the coating layer 310 and may include a polymer material. According to an embodiment, the protective layer 320 may be disposed across the first display area 231, the folding area 233, and the second display area 232 of the flexible display 230. A portion of the protective layer 320 disposed in the folding area 233 may be bent and/or rolled in response to the bending and/or rolling of the flexible display 230.

According to an embodiment, the first adhesive layer 330 may be disposed beneath the protective layer 320 and may include multiple materials, each of which may be disposed in a compartmentalized manner. For example, the first adhesive layer 330 may bond the protective layer 320 and the glass layer 340. The first adhesive layer 330 may include a first adhesive portion 331 and a second adhesive portion 333. For example, the first adhesive portion 331 may be an optically clear adhesive (OCA), and the second adhesive portion 333 may be an optically clear resin (OCR).

According to an embodiment, the first adhesive portion 331 and the second adhesive portion 333 may have different hardnesses. For example, the hardness of the first adhesive portion 331 may be smaller than the hardness of the second adhesive portion 333.

According to an embodiment, the first adhesive portion 331 and the second adhesive portion 333 may have different Young's moduli. According to an embodiment, the Young's modulus of the first adhesive portion 331 may be smaller than the Young's modulus of the second adhesive portion 333. For example, the first adhesive portion 331 may have a Young's modulus in the range of about 0.5 to 1,000 kPa, and the second adhesive portion 333 may have a Young's modulus in the range of about 2 to 1,000 MPa. The first adhesive portion 331 may provide higher viscoelastic properties than the second adhesive portion 333 due to its relatively lower Young's modulus compared to the second adhesive portion 333. The first adhesive portion 331 may be used after being applied to and cured in a required area after bonding, or may be used as a sheet type. The second adhesive portion 333 may be used after being applied to and cured in a required area after bonding.

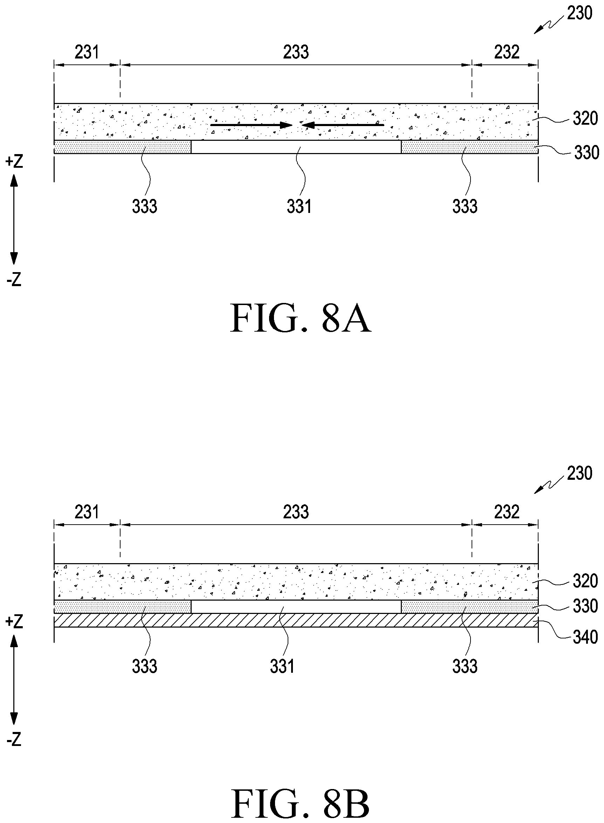

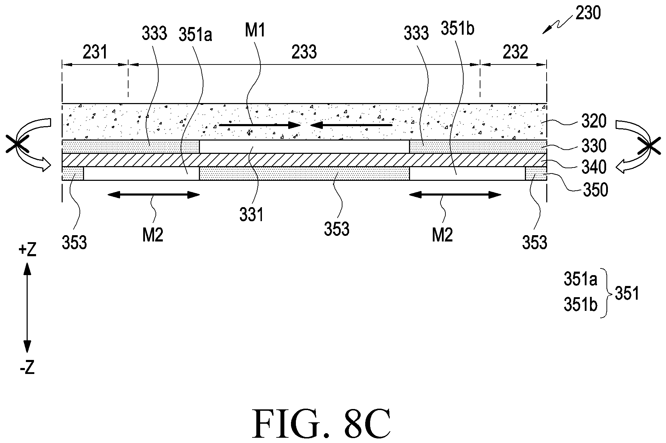

According to an embodiment, the first adhesive portion 331 of the first adhesive layer 330 may be disposed in the folding area 233 of the flexible display 230, while the second adhesive portion 333 may be disposed in the first display area 231, the second display area 232, and the folding area 233 of the flexible display 230. The second adhesive portion 333 may enclose the side surface of the first adhesive portion 331. For example, the first adhesive portion 331 may be have a length corresponding to the length of the folding area 233 (e.g., the length in the Y-axis direction) and a width smaller than the width of the folding area 233 (e.g., the width in the X-axis direction). The second adhesive portion 333 may be disposed in the first display area 231 and the second display area 232, as well as in a portion of the folding area 233 where the first adhesive portion 331 is not disposed. The second adhesive portion 333 arranged along the edges of the first adhesive portion 331 may enclose the first adhesive portion 331 inward, thereby preventing or reducing the movement of the first adhesive portion 331 that occurs during the process due to the difference in fluidity between the first adhesive portion 331 and the second adhesive portion 333 (see FIG. 8).

According to an embodiment, the thermal expansion coefficients of the protective layer 320 and the first adhesive portion 331 of the first adhesive layer 330, which are in contact with each other in the folding area 233 of the flexible display 230, may differ from each other. For example, the thermal expansion coefficient of the first adhesive portion 331 of the first adhesive layer 330 may be greater than that of the protective layer 320. As a result, as the temperature changes during the process (e.g., the temperature decreases after increases), the shrinkage of the protective layer 320 may be relatively smaller, leaving tensile stress in the first adhesive portion 331 and compressive stress beneath the protective layer 320. The compressive stress acting beneath the protective layer 320 is directed in the opposite direction to the tensile stress, which is the main cause of permanent deformation of the protective layer 320, and thus may suppress the wrinkling of the flexible display 230.

According to an embodiment, the glass layer 340 may be disposed on the second adhesive layer 350. For the glass layer 340, foldable thin glass (FTG), which is bendable, may be used. According to an embodiment, the glass layer 340 may be disposed across the first display area 231, the folding area 233, and the second display area 232 of the flexible display 230. A portion of the glass layer 340 disposed in the folding area 233 may be bent and/or rolled in response to the bending and/or rolling of the flexible display 230.

According to an embodiment, the second adhesive layer 350 may be disposed beneath the protective layer 320 and may include multiple materials, each of which may be disposed in a compartmentalized manner. For example, the second adhesive layer 350 may bond the glass layer 340 and the display panel 360. The second adhesive layer 350 may include a third adhesive portion 351 and a fourth adhesive portion 353. For example, the third adhesive portion 351 may be an optically clear adhesive (OCA), and the fourth adhesive portion 353 may be an optically clear resin (OCR).

According to an embodiment, the third adhesive portion 351 and the fourth adhesive portion 353 may have different hardnesses. For example, the hardness of the third adhesive portion 351 may be smaller than the hardness of the fourth adhesive portion 353.

According to an embodiment, the third adhesive portion 351 and the fourth adhesive portion may have different Young's moduli. According to an embodiment, the Young's modulus of the third adhesive portion 351 may be smaller than the Young's modulus of the fourth adhesive portion 353. For example, the third adhesive portion 351 may have a Young's modulus in the range of 0.5 to 1,000 kPa, and the fourth adhesive portion 353 may have a Young's modulus in the range of 2 to 1,000 MPa. The third adhesive portion 351 may provide viscoelastic properties due to its relatively low Young's modulus compared to the fourth adhesive portion 353. The third adhesive portion 351 may be used after being applied to and cured in a required area after bonding, or may be used as a sheet type. The fourth adhesive portion 353 may be used after being applied to and cured in a required area after bonding.

According to an embodiment, the first adhesive portion 331 and the third adhesive portion 351 may be an optically clear adhesive (OCA) and may have different thermal expansion coefficients. For example, the thermal expansion coefficient of the third adhesive portion 351 may be smaller than the thermal expansion coefficient of the first adhesive portion 331.

According to an embodiment, the third adhesive portion 351 of the second adhesive layer 350 may be disposed in the first display area 231 and/or the second display area 232 adjacent to the folding area 233, and the fourth adhesive portion 353 may be disposed in the first display area 231, the second display area 232, and the folding area 233. The fourth adhesive portion 353 may enclose the side surface of the third adhesive portion 351.

According to an embodiment, the third adhesive portion 351 of the second adhesive layer 350 may be formed in multiple pieces. For example, the third adhesive portion 351 may include a (3-1)th adhesive portion 351a and a (3-2)th adhesive portion 351b spaced apart from the (3-1)th adhesive portion 351a. According to an embodiment, the (3-1)th adhesive portion 351a may extend from one end of the folding area 233 along the longitudinal direction (e.g., the Y-axis direction) to a portion of the first display area 231. The (3-1)th adhesive portion 351a may have a size smaller than the width of the first display area 231 (e.g., the width in the X-axis direction). According to an embodiment, the (3-2)th adhesive portion 351b may extend from the other end of the folding area 233 along the length direction (e.g., the Y-axis direction) to a portion of the second display area 232. The (3-2)th adhesive portion 351b may have a size smaller than the width of the second display area 232 (e.g., the width in the X-axis direction).

According to an embodiment, the fourth adhesive portion 353 may be disposed in the first display area 231 and the second display area 232 where the third adhesive portion 351 is not disposed, as well as in the folding area 233. The fourth adhesive portion 353 arranged along the edges of the third adhesive portion 351 may enclose the third adhesive portion 351 inward, thereby preventing or reducing the movement of the third adhesive portion 351 that occurs during the process due to the difference in fluidity between the third adhesive portion 351 and the fourth adhesive portion 353.

According to an embodiment, when the flexible display 230 is viewed from below or above (e.g., in the +Z-axis direction or the -Z-axis direction), the first adhesive portion 331 of the first adhesive layer 330 and the third adhesive portion 351 of the second adhesive layer 350 may be arranged so as not to overlap each other. For example, the first adhesive portion 331 may be disposed in the folding area 233, and the third adhesive portion 351 may be disposed in the first display area 231 and/or the second display area 232 adjacent to the folding area 233.

According to an embodiment, when the flexible display 230 is viewed from below or above (e.g., in the +Z-axis direction or the -Z-axis direction), the first adhesive portion 331 of the first adhesive layer 330 and the fourth adhesive portion 353 of the second adhesive layer 350 may be arranged to at least partially overlap each other. All side surfaces of the first adhesive portion 331 may be confined by the closed loop shape of the second adhesive portion 333, the upper surface (e.g., the surface facing the +Z-axis direction) may be confined by the protective layer 320, and the bottom surface (e.g., the surface facing the -Z-axis direction) may be confined by the glass layer 340.

According to an embodiment, when the flexible display 230 is viewed from below or above (e.g., in the +Z-axis direction or the -Z-axis direction), the second adhesive portion 333 of the first adhesive layer 330 may at least partially overlap the third adhesive portion 351 of the second adhesive layer 350. All side surfaces of the third adhesive portion 351 may be confined by the closed loop shape of the fourth adhesive portion 353, the upper surface (e.g., the surface facing the +Z-axis direction) may be confined by the glass layer 340, and the bottom surface (e.g., the surface facing the -Z-axis direction) may be confined by display panel 360.

According to an embodiment of the disclosure, as the first adhesive layer 330 and the second adhesive layer 350 are arranged with the glass layer 340 interposed therebetween, and multiple adhesive portions are separately arranged on each of the first adhesive layer 330 and/or the second adhesive layer 350, tensile/compressive stress and strain concentrated in the folding area 233 of the flexible display 230 may be distributed.

FIG. 8A is a schematic view illustrating a part of the process for laminating a flexible display according to an embodiment disclosed herein.

FIG. 8B is a schematic view illustrating another part of the process for laminating a flexible display according to an embodiment disclosed herein.

FIG. 8C is a schematic view illustrating yet another part of the process for laminating a flexible display according to an embodiment disclosed herein.

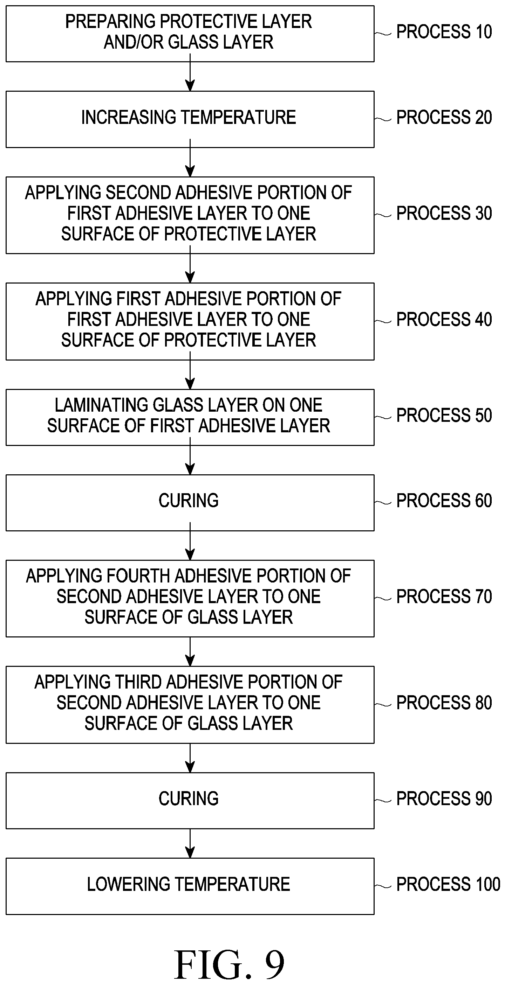

FIG. 9 is a flowchart illustrating the process for laminating a flexible display according to an embodiment disclosed herein.

According to an embodiment, the flexible display 230 may include a display panel (e.g., the display panel 360 in FIG. 5) and multiple films laminated for the display panel. The multiple films may include a protective layer 320, a first adhesive layer 330, a glass layer 340, and a second adhesive layer 350. The configurations of the protective layer 320, the first adhesive layer 330, the glass layer 340, and the second adhesive layer 350 of FIGS. 8A, 8B, 8C, and 9 may be partially or entirely identical to the configurations of the protective layer 320, the first adhesive layer 330, the glass layer 340, and the second adhesive layer 350 of FIGS. 5, 6, and 7. The structures of FIGS. 8A, 8B, 8C, and 9 may be optionally combined with the structures of FIGS. 5, 6, and 7.

Hereinafter, the process of laminating multiple films (e.g., the protective layer 320, the first adhesive layer 330, the glass layer 340, and the second adhesive layer 350) disposed on a display panel (e.g., the display panel 360 of FIG. 5) will be described.

According to process 10, the protective layer 320 and/or the glass layer 340 may be fabricated to correspond to the size of the display panel. For example, the protective layer 320 and/or the glass layer 340 may be cut by a laser source so as to cover the display panel. According to an embodiment, the protective layer 320 may be made of a soft material. For example, the protective layer 320 may include a polymer material. According to an embodiment, for the glass layer 340, foldable thin glass (FTG), which is bendable, may be used. The protective layer 320 and the glass layer 340 may be disposed across the first display area 231, the folding area 233, and the second display area 232 of the flexible display 230. The portions of the protective layer 320 and the glass layer 340 disposed in the folding area 233 may be bent and/or rolled in response to the bending and/or rolling of the flexible display 230.

According to process 20, in order to dispose the first adhesive layer 330 on one surface (e.g., the surface facing the -Z-axis direction) of the protective layer 320, the process temperature may be increased to a high temperature. The high temperature may be, for example, in the range of about 35 to 80°C. Changing the process temperature (from high temperature to low temperature (e.g., room temperature)) may be performed to apply stress to the folding area 233 depending on the difference in thermal expansion coefficient between the first adhesive layer 330 and the protective layer 320, which will be described later.

According to process 30 (see FIG. 8A), under the high-temperature conditions, the second adhesive portion 333 of the first adhesive layer 330 may be applied (or coated) on one surface (e.g., the surface facing the -Z-axis direction) of the protective layer 320. According to an embodiment, the second adhesive portion 333 may be an optically clear resin (OCR). The second adhesive portion 333 may be applied to the first display area 231, the second display area 232, and the folding area 233 of the flexible display 230. For example, the second adhesive portion 333 may be applied to an area excluding an area where the first adhesive portion 331 is to be disposed (e.g., a portion of the folding area 233). The second adhesive portion 333 may have a shape including an opening so that a portion of the folding area 233 is excluded.

According to process 40 (see FIG. 8A), under the high-temperature conditions, the first adhesive portion 331 of the first adhesive layer 330 may be applied (or coated) on one surface (e.g., the surface facing the -Z-axis direction) of the protective layer 320. According to an embodiment, the second adhesive portion 333 may be an optically clear adhesive (OCA). The first adhesive portion 331 may be applied to a portion of the folding area 233 of the flexible display 230.

According to an embodiment, process 30 and process 40 may be optionally changed in order depending on the manufacturing conditions. For example, the order of process 10, process 20, process 30, and process 40 may be performed in that order, or the process 10, the process 20, the process 40, and the process 30 may be performed in that order.

According to process 50 (see FIG. 8B), the glass layer 340 may be disposed on one surface (e.g., the surface facing the -Z-axis direction) of the first adhesive layer 330. The glass layer 340 may be disposed and bonded (e.g., laminated) to the protective layer 320 by the first adhesive layer 330.

According to an embodiment, when process 30, process 40, and process 50 (or process 40, process 30, and process 50) are sequentially performed, the first adhesive layer 330 may be disposed such that different adhesive materials are distinguished depending on their positions. The first adhesive portion 331 may have a Young's modulus in the range of about 0.5 to 1,000 kPa, and the second adhesive portion 333 may have a Young's modulus in the range of about 2 to 1,000 MPa, so that they may be distinguished from each other. In the first adhesive layer 330, the second adhesive portion 333 may be formed to enclose the side surface of the first adhesive portion 331. The upper surface (e.g., the surface facing the +Z-axis direction) of the first adhesive portion 331 may be covered by the protective layer 320, and the bottom surface (e.g., the surface facing the -Z-axis direction) of the first adhesive portion 331 may be covered by the glass layer 340, so that the outer surface of the first adhesive portion 331 may be entirely enclosed by another material (hereinafter, referred to as a confinement structure).

According to an embodiment, since the first adhesive portion 331 is disposed to be in contact with the protective layer 320 in the folding area 233 of the flexible display 230, the wrinkling of the protective layer 320, which is caused when the flexible display 230 is bent, may be suppressed. In addition, since the confinement structure is formed such that the entire surfaces of the first adhesive portion 331 are enclosed by the second adhesive portion 333, the protective layer 320, and the glass layer 340, the flow of the first adhesive portion 331 may be prevented or reduced.

Hereinafter, with reference to FIG. 8A and Equation 1, a process for preventing or reducing wrinkles of the protective layer 320 when the flexible display 230 is bent will be described.

[Equation 1]

$$p = \varepsilon E$$

$p$: Internal stress (thermal stress) per unit area of adhesive layer
$\varepsilon$: Thermal expansion coefficient
$E$: Young's modulus of adhesive
$\varepsilon = \Delta t \Delta a$
$\Delta t$: Difference between boding temperature or Tg and room temperature
$\Delta a$: Difference in thermal expansion coefficient

Equation 1 represents the residual stress generated within the adhesive due to the difference in thermal expansion coefficients between the adherend and the adhesive.

According to an embodiment, the thermal expansion coefficient (or thermal expansion rate) of the first adhesive portion 331 of the first adhesive layer 330 is greater than the thermal expansion coefficient (or thermal expansion rate) of the protective layer 320, and due to the difference in the thermal expansion coefficients between the first adhesive portion 331 and the protective layer 320, the first adhesive portion 331 may transfer stress to the protective layer 320. For example, at a high temperature (e.g., a temperature higher than room temperature), in the first adhesive portion 331, when the temperature is lowered (e.g., to room temperature) after the bonding process of the protective layer 320 is completed, the films laminated on the flexible display 230 may shrink as a whole. In this case, since the thermal expansion coefficient of the protective layer 320 is smaller than that of the first adhesive portion 331, the shrinkage of the protective layer 320 becomes relatively smaller. As a result, tensile stress may remain in the first adhesive portion 331, and compressive stress may remain in the lower portion of the protective layer 320. The compressive stress acting beneath the protective layer 320 is directed in the opposite direction to the tensile stress, which is the main cause of permanent deformation of the protective layer 320, and thus may suppress the wrinkling of the display.

Referring to Table 1 below, the stress values of the protective layer (e.g., a polymer layer (PL layer)) in an improved embodiment may be identified compared to a conventional laminated structure (e.g., an adhesive layer formed as a single layer (e.g., a pressure-sensitive adhesive (PSA)). The stress of the protective layer 320, which is the main cause of wrinkles in the flexible display 230, was compared. It was identified that the tensile stress in the folding area 233 of the flexible display 230, which is the cause of wrinkles, was reduced by about 2.3% compared to the conventional laminated structure.

Table 1]

| Protective Layer (PL layer) | Conventional Laminated Structure | Embodiment | Reduced Rate (%) |
|---|---|---|---|
| Max principal stress (Mpa) | 125.7 | 122.8 | 2.3% |

Hereinafter, a configuration will be described which is capable of preventing or reducing the flow of the first adhesive portion 331 by forming the confinement structure to enclose the entire surfaces of the first adhesive portion 331 of the first adhesive layer 330.

When the first adhesive portion 331 is applied to the protective layer 320 under high-temperature conditions and then the temperature is lowered to a lower temperature (e.g., room temperature), compressive stress is initially applied, but due to the viscoelastic properties of the first adhesive portion 331, the applied stress may be relieved over time. As the first adhesive portion 331 flows and moves from its initial position due to its viscoelastic properties, the stress is relieved. This phenomenon may be prevented or reduced by confining the first adhesive portion 331 using the second adhesive portion 333. Since the first adhesive portion 331 does not exhibit viscoelasticity after curing (e.g., process 60), application of the second adhesive portion 333 that covers all side surfaces of the first adhesive portion 331 may be required. According to an embodiment, the second adhesive portion 333 may be formed to enclose the side surface of the first adhesive portion 331. The upper surface (e.g., the surface facing the +Z-axis direction) of the first adhesive portion 331 may be covered by the protective layer 320, and the bottom surface (e.g., the surface facing the -Z-axis direction) of the first adhesive portion 331 may be covered by the glass layer 340 described later, so that the outer surface of the first adhesive portion 331 may be entirely enclosed by another material.

According to process 60, the curing process may be performed in the state in which the protective layer 320, the first adhesive layer 330, and the glass layer 340 are laminated. The curing process may cure the first adhesive layer 330 by using strong energy of ultraviolet (UV) rays generated from a lamp.

According to process 70 (see FIG. 8C), under the high-temperature conditions, the fourth adhesive portion 353 of the second adhesive layer 350 may be applied (or coated) on one surface (e.g., the surface facing the -Z-axis direction) of the glass layer 340. According to an embodiment, the fourth adhesive portion 353 may be an optically clear resin (OCR). The fourth adhesive portion 353 may be applied to the first display area 231, the second display area 232, and the folding area 233 of the flexible display 230. For example, the fourth adhesive portion 353 may be applied to an area excluding the area where the third adhesive portion 351 is to be disposed. The fourth adhesive portion 353 may have a shape including an opening so that a portion of the first display area 231 and/or the second display area adjacent to the folding area 233 is excluded. For example, the fourth adhesive portion 353 may be applied to one surface (e.g., the surface facing the -Z-axis direction) of the glass layer 340 such that a portion of the first display area 231 where the (3-1)th adhesive portion 351a is disposed and a portion of the second display area 232 where the (3-2)th adhesive portion 351b is disposed are open.

According to process 80 (see FIG. 8C), under the high-temperature conditions, the third adhesive portion 351 of the second adhesive layer 350 may be applied (or coated) on one surface (e.g., the surface facing the -Z-axis direction) of the glass layer 340. According to an embodiment, the third adhesive portion 351 may be an optically clear adhesive (OCA). The third adhesive portion 351 may be applied to a portion of the first display area 231 and/or the second display area adjacent to the folding area 233. For example, the third adhesive portion 351 may include a (3-1)th adhesive portion 351a and a (3-2)th adhesive portion 351b spaced apart from each other with the folding area 233 interposed therebetween. The (3-1)th adhesive portion 351a may be applied to a portion of the first display area 231 that is in contact with the folding area 233, and the (3-2)th adhesive portion 351b may be applied to a portion of the second display area 232 that is in contact with the folding area 233.

According to an embodiment, process 70 and process 80 may be optionally changed in order depending on the manufacturing conditions. For example, after the above-mentioned previous processes (processes 10 to 60), process 70 and process 80 may be performed in that order, or process 80 and process 70 may be performed in that order.

According to an embodiment, when process 70 and process 80 (or process 80 and process 70) are sequentially performed, the second adhesive layer 350 may be disposed such that different adhesive materials are distinguished depending on their positions. The third adhesive portion 351 may have a Young's modulus in the range of about 0.5 to 1,000 kPa, and the fourth adhesive portion 353 may have a Young's modulus in the range of about 2 to 1,000 MPa, so that they may be distinguished from each other. In the second adhesive layer 350, the fourth adhesive portion 353 may be formed to enclose the side surfaces of the third adhesive portion 351. The upper surface (e.g., the surface facing the +Z-axis direction) of the third adhesive portion 351 may be covered by the glass layer 340, and the bottom surface (e.g., the surface facing the -Z-axis direction) of the third adhesive portion 351 may be covered by the display panel 360, so that the outer surface of the third adhesive portion 351 may be entirely enclosed by another material (hereinafter, referred to as a confinement structure).

According to an embodiment, when the first adhesive layer 330 and the second adhesive layer 350 are applied to face each other with the glass layer 340 interposed therebetween, the warping of the protective layer 320, which may be caused due to the compressive stress in the first adhesive layer 330, may be prevented or reduced. In addition, through the confinement structure in which the third adhesive portion 351 of the second adhesive layer 350 is disposed so as not to face the folding area 233, and the fourth adhesive portion 353 is disposed to enclose the third adhesive portion 351, the breakage of the folding area 233 of the flexible display (e.g., the glass layer 340) may be prevented or reduced.

Hereinafter, a process for preventing or reducing the warping of the protective layer 320 will be described with reference to FIG. 8C and Equation 1 described above.

When only the first adhesive layer (e.g., the first adhesive portion 331) is applied to one surface of the protective layer 320 under the high-temperature conditions and then the temperature is lowered, a first moment M1, which tends to fold inward about the folding axis, may be generated due to the compressive stress in the lower portion of the protective layer 320 generated by the first adhesive layer 330. This appears as the warping of the protective layer 320, which may make it difficult to laminate the glass layer 340 later. According to an embodiment, by applying the glass layer 340 and the second adhesive layer 350 to the lower portion of the first adhesive layer 330 before the temperature is lowered, the warping of the protective layer 320 may be prevented or reduced. For example, since tensile stress through the second adhesive layer 350 is provided to the lower portion of the glass layer 340 (e.g., the surface facing the -Z-axis direction), a second moment M2 in the opposite direction to the first moment M1 can be provided. The second adhesive layer (e.g., the third adhesive portion 351), which has a thermal expansion coefficient smaller than that of the glass layer 340 and a thermal expansion coefficient different from that of the first adhesive layer (e.g., the first adhesive portion 331), may provide tensile stress of the second moment M2.

Hereinafter, a structure capable of preventing or reducing breakage of the folding area 233 of a flexible display (e.g., the glass layer 340) will be described. When the third adhesive portion 351 of the second adhesive layer 350 is applied to the lower portion of the folding region of the glass layer 340, tensile stress may be directly provided to the glass layer 340, and thus breakage of the glass layer 340 may occur. According to an embodiment, since the third adhesive portion 351 of the second adhesive layer 350 is applied to a portion of the first display area 231 and/or the second display area adjacent to the folding area 233, which prevents tensile stress from being directly applied to the folding area of the glass layer 340, breakage may be prevented or reduced, and warping of the protective layer 320 may be prevented or reduced.

According to an embodiment, since the confinement structure is formed such that the entire surfaces of the third adhesive portion 351 are enclosed by the fourth adhesive portion 353, the glass layer 340, and the display panel 360, the flow of the third adhesive portion 351 may be prevented or reduced. When the third adhesive portion 351 is applied under high-temperature conditions and then the temperature is lowered to a lower temperature (e.g., room temperature), tensile stress is initially applied, but due to the viscoelastic properties of the third adhesive portion 351, the applied stress may be relieved over time. As the third adhesive portion 351 flows and moves from its initial position due to its viscoelastic properties, the stress is relieved. This phenomenon may be prevented or reduced by confining the third adhesive portion 351 using the fourth adhesive portion 353.

According to process 90, the curing process may be performed in the state in which the glass layer 340 and the second adhesive layer 330 are laminated. The curing process may cure the second adhesive layer 350 by using strong energy of ultraviolet (UV) rays generated from a lamp.

According to process 100, after the protective layer 320, the first adhesive layer 330, the glass layer 340, and the second adhesive layer 350 are laminated and cured, a process of lowering the temperature to a low temperature (e.g., room temperature) may be performed. Even when the temperature is lowered, the first adhesive portion 331 of the first adhesive layer 330 and/or the third adhesive portion 351 of the second adhesive layer 350 may not flow due to stress relaxation by the confinement structure.

In an electronic device including a flexible display, the flexible display may use one adhesive layer (e.g., a pressure-sensitive adhesive (PSA)) per layer for interlayer bonding of multiple films. When the electronic device is folded, the multiple films of the flexible display may experience compressive stress and/or tensile stress. Among these, the layers made of soft materials (e.g., polymers) are vulnerable to plastic deformation, and permanent deformation may occur when folding is repeated or in a high-temperature and high-humidity environment. As a result, a crease shape that can be visually or tactilely felt by a user may be formed in a folding area of the flexible display.

According to an embodiment of the disclosure, in a flexible display of an electronic device, an adhesive layer (e.g., the first adhesive layer) bonded to the protective layer may be arranged into multiple layers that can be distinguished from area to area, thereby providing structural improvement and process change of the adhesive layer. Accordingly, the wrinkling of the flexible display may be suppressed by applying compressive stress to the adhesive layer.

According to an embodiment of the disclosure, an electronic device 101 may include a first housing 210, a second housing 220 configured to rotate or slide relative to the first housing, and a flexible display 230 configured to be unfolded or bent based on relative movement of the second housing and including a first display area 231, a second display area 232, and a folding area 233 connecting the first display area and the second display area. The flexible display may include a protective layer 320, a first adhesive layer 330 disposed beneath the protective layer and including a first adhesive portion 331 disposed in the folding area, and a second adhesive portion 333 provided to enclose the side surface of the first adhesive portion, a second adhesive layer 350 disposed beneath the first adhesive layer including a third adhesive portion 351 disposed in each of the first and second display areas, which are adjacent to the folding area, and a fourth adhesive portion 353 provided to enclose the side surface of the third adhesive portion, and a display panel 360 disposed beneath the second adhesive layer. For example, the flexible display 230 may include the first adhesive layer 330 disposed between the protective layer 320 and the display panel 260, and including the first adhesive portion 331 disposed in the folding area, and the second adhesive portion 333 provided to enclose a side surface of the first adhesive portion. The flexible display 230 may include a second adhesive layer 350 disposed between the first adhesive layer 330 and the display panel 260 and including the third adhesive portion 351 disposed in each of the first and second display areas, which are adjacent to the folding area, and the fourth adhesive portion 353 provided to enclose the side surface of the third adhesive portion.

According to an embodiment, the electronic device may further include a glass layer 340 disposed between the first adhesive layer and the second adhesive layer.

According to an embodiment, the first adhesive portion of the first adhesive layer may have a hardness smaller than the hardness of the second adhesive portion of the first adhesive layer.

According to an embodiment, the third adhesive portion of the second adhesive layer may have a hardness smaller than the hardness of the fourth adhesive portion of the second adhesive layer.

According to an embodiment, the first adhesive portion of the first adhesive layer may be disposed in a portion of the folding area, and the second adhesive portion of the first adhesive layer may be disposed in another portion of the folding area, the first display area, and the second display area.

According to an embodiment, in the first adhesive layer, the upper surface of the first adhesive portion facing a first direction may be bonded to the protective layer, and the bottom surface of the first adhesive portion facing a second direction opposite to the first direction may be bonded to the glass layer.

According to an embodiment, in the second adhesive layer, the third adhesive portion may include a $(3\text{-}1)^{th}$ adhesive portion (351a) and a $(3\text{-}2)^{th}$ adhesive portion (351b) which are spaced apart from each other with the folding area being interposed therebetween.

According to an embodiment, the $(3\text{-}1)^{th}$ adhesive portion of the third adhesive portion may extend from one end of the folding area to a portion of the first display area, and the $(3\text{-}2)^{th}$ adhesive portion of the third adhesive portion may extend from another end of the folding area to a portion of the second display area. The fourth adhesive portion may be disposed in the folding area and the other areas of the first and second display areas.

According to an embodiment, the upper surface of the third adhesive portion facing a first direction may be bonded to the glass layer, and the bottom surface of the third adhesive portion facing a second direction opposite to the first direction may be bonded to the display panel.

According to an embodiment, the first adhesive portion of the first adhesive layer may have a thermal expansion coefficient greater than the thermal expansion coefficient of the protective layer, and due to a difference in the thermal expansion coefficients, the folding area of the protective layer may be formed to generate compressive stress. The third adhesive portion of the second adhesive layer may have a thermal expansion coefficient smaller than the thermal expansion coefficient of the glass layer, and the thermal expansion coefficient of the third adhesive portion of the second adhesive layer may differ from the thermal expansion coefficient of the first adhesive portion of the first adhesive layer.

According to an embodiment, the first adhesive portion of the first adhesive layer and the third adhesive portion of the second adhesive layer may include optically clear adhesives (OCAs) having different Young's moduli.

According to an embodiment, the second adhesive portion of the first adhesive layer and the fourth adhesive portion of the second adhesive layer may include optically clear resins (OCRs) having different Young's moduli.

According to an embodiment, the first adhesive portion of the first adhesive layer may have a Young's modulus smaller than or equal to the Young's modulus of the second adhesive portion.

According to an embodiment, the third adhesive portion of the second adhesive layer may have a Young's modulus smaller than or equal to the of the Young's modulus of the fourth adhesive portion.

According to an embodiment, the first adhesive portion of the first adhesive layer may overlap at least a portion of the fourth adhesive portion of the second adhesive layer.

According to an embodiment, the third adhesive portion of the second adhesive layer may overlap at least a portion of the second adhesive portion of the first adhesive layer.

According to an embodiment of the disclosure, a method of manufacturing a flexible display 230 may include a process of cutting a protective layer 320 and a glass layer 340 to correspond to the size of a display panel 360 (process 10), a process of increasing temperature to bond a first adhesive layer 330 to the protective layer (process 20), a process of applying or coating the first adhesive layer, which is divided into a first adhesive portion 331 and a second adhesive portion 333 having different Young's moduli, onto the bottom surface of the protective layer (process 30; process 40), a process of bonding the glass layer 340 to the bottom surface of the first adhesive layer (process 50), a process of applying or coating the second adhesive layer 350, which is divided into a third adhesive portion 351 and a fourth adhesive portion 353 having different Young's moduli, onto the bottom surface of the glass layer (process 70; process 80), and a process of lowering the increased temperature to room temperature (process 100).

According to an embodiment, the process of applying or coating the first adhesive layer, which is divided into the first adhesive portion and the second adhesive portion having different Young's moduli, onto the bottom surface of the protective layer may include a process of arranging the first adhesive portion in the folding area of the protective layer, and a process of arranging the second adhesive portion in the first display area and the second display area arranged at opposite ends of the folding area of the protective layer. The second adhesive portion may be formed to enclose a side surface of the first adhesive portion.

According to an embodiment, the process of applying or coating the second adhesive layer, which is divided into the third adhesive portion and the fourth adhesive portion having different Young's moduli, onto the bottom surface of the glass layer may include the process of arranging the third adhesive portion in portions of the first and second display areas adjacent to the folding area of the protective layer, and the process of arranging the fourth adhesive portion in the folding area of the protective layer and other positions of the first and second display areas. The fourth adhesive portion may be provided to enclose a side surface of the third adhesive portion.

According to an embodiment, the first adhesive portion of the first adhesive layer may have a thermal expansion coefficient greater than the thermal expansion coefficient of the protective layer, and due to a difference in the thermal expansion coefficients, the folding area of the protective layer may be formed to generate compressive stress.

According to an embodiment, The third adhesive portion of the second adhesive layer may have a thermal expansion coefficient smaller than the thermal expansion coefficient of the glass layer, and the thermal expansion coefficient of the third adhesive portion of the second adhesive layer may differ from the thermal expansion coefficient of the first adhesive portion of the first adhesive layer.

## Claims

1. An electronic device (101) comprising:

   a first housing (210);
   a second housing (220) configured to rotate or slide relative to the first housing; and
   a flexible display (230) configured to be unfolded or bent based on relative movement of the second housing, wherein the flexible display comprises a first display area (231), a second display area (232), and a folding area (233) connecting the first display area and the second display area;
   wherein the flexible display comprises:

   a protective layer (320);
   a first adhesive layer (330) disposed beneath the protective layer, wherein the first adhesive layer comprises a first adhesive portion (331) disposed in the folding area, and a second adhesive portion (333) provided to enclose the side surface of the first adhesive portion;
   a second adhesive layer (350) disposed beneath the first adhesive layer, wherein the second adhesive layer comprises a third adhesive portion (351) disposed in each of the first and second display areas, which are adjacent to the folding area, and a fourth adhesive portion (353) provided to enclose the side surface of the third adhesive portion; and
   a display panel (360) disposed beneath the second adhesive layer.

2. The electronic device of claim 1, further comprising:
   a glass layer (340) disposed between the first adhesive layer and the second adhesive layer.

3. The electronic device according to claim 1 or 2,

wherein the first adhesive portion of the first adhesive layer has a hardness smaller than a hardness of the second adhesive portion of the first adhesive layer, and
wherein the third adhesive portion of the second adhesive layer has a hardness smaller than the hardness of the fourth adhesive portion of the second adhesive layer.

4. The electronic device of one of claims 1 to 3,
wherein the first adhesive portion is disposed in a portion of the folding area, and the second adhesive portion is disposed in another portion of the folding area, the first display area, and the second display area.

5. The electronic device of one of claims 2 to 4,
wherein a upper surface of the first adhesive portion facing a first direction is bonded with the protective layer, and a lower surface of the first adhesive portion facing a second direction opposite to the first direction is bonded with the glass layer.

6. The electronic device of one of claims 1 to 4,

wherein the third adhesive portion comprises a $(3-1)^{th}$ adhesive portion (351a) and a $(3-2)^{th}$ adhesive portion (351b) which are spaced apart from each other with the folding area being interposed therebetween,
wherein the $(3-1)^{th}$ adhesive portion extends from one end of the folding area to a portion of the first display area, and the $(3-2)^{th}$ adhesive portion extends from another end of the folding area to a portion of the second display area, and
wherein the fourth adhesive portion is disposed in the folding area and other areas of the first and second display areas.

7. The electronic device of one of claims 2 to 4,

wherein a upper surface of the third adhesive portion facing a first direction is bonded to the glass layer, and
wherein a lower surface of the third adhesive portion facing a second direction opposite to the first direction is bonded to the display panel.

8. The electronic device of one of claims 2 to 7,

wherein the first adhesive portion of the first adhesive layer has a thermal expansion coefficient greater than a thermal expansion coefficient of the protective layer, and
wherein due to a difference in the thermal expansion coefficients, the folding area of the protective layer is formed to generate compressive stress.

9. The electronic device of one of claims 2 to 8,

wherein the third adhesive portion of the second adhesive layer has a thermal expansion coefficient smaller than a thermal expansion coefficient of the glass layer, and
wherein the thermal expansion coefficient of the third adhesive portion of the second adhesive layer differs from the thermal expansion coefficient of the first adhesive portion of the first adhesive layer.

10. The electronic device of one of claims 2 to 9,
wherein the first adhesive portion of the first adhesive layer and the third adhesive portion of the second adhesive layer comprise optically clear adhesives (OCAs) having different Young's moduli.

11. The electronic device of one of claims 2 to 9,
wherein the second adhesive portion of the first adhesive layer and the fourth adhesive portion of the second adhesive layer comprise optically clear resins (OCRs) having different Young's moduli.

12. The electronic device of one of claims 2 to 9,
wherein the first adhesive portion of the first adhesive layer has a Young's modulus smaller than or equal to a Young's modulus of the second adhesive portion of the first adhesive layer.

**13.** The electronic device of one of claims 2 to 9,
wherein the third adhesive portion of the second adhesive layer has a Young's modulus smaller than or equal to a Young's modulus of the fourth adhesive portion of the second adhesive layer.

**14.** The electronic device of one of claims 2 to 13,
wherein the first adhesive portion of the first adhesive layer overlaps at least a portion of the fourth adhesive portion of the second adhesive layer.

**15.** The electronic device of one of claims 2 to 13,
wherein the third adhesive portion of the second adhesive layer overlaps at least a portion of the second adhesive portion of the first adhesive layer.

FIG. 1

FIG. 2

# FIG. 3

101

214

230

224

212

222

280-1

280-2

252

242

240

262

254

264

270

+Z

-Z

226

216

$280 \begin{cases} 280\text{-}1 \\ 280\text{-}2 \end{cases}$

$250 \begin{cases} 252 \\ 254 \end{cases}$

$260 \begin{cases} 262 \\ 264 \end{cases}$

$220 \begin{cases} 222 \\ 224 \\ 226 \end{cases}$   $210 \begin{cases} 212 \\ 214 \\ 216 \end{cases}$

FIG. 4

FIG. 5

231 233 232 →330

X

Y

333 331 333

# FIG. 6

231 233 232 →350

X

Y

353 351a 353 351b 353

351a } 351
351b

# FIG. 7

# FIG. 8A

# FIG. 8B

FIG. 8C

PREPARING PROTECTIVE LAYER AND/OR GLASS LAYER — PROCESS 10

↓

INCREASING TEMPERATURE — PROCESS 20

↓

APPLYING SECOND ADHESIVE PORTION OF FIRST ADHESIVE LAYER TO ONE SURFACE OF PROTECTIVE LAYER — PROCESS 30

↓

APPLYING FIRST ADHESIVE PORTION OF FIRST ADHESIVE LAYER TO ONE SURFACE OF PROTECTIVE LAYER — PROCESS 40

↓

LAMINATING GLASS LAYER ON ONE SURFACE OF FIRST ADHESIVE LAYER — PROCESS 50

↓

CURING — PROCESS 60

↓

APPLYING FOURTH ADHESIVE PORTION OF SECOND ADHESIVE LAYER TO ONE SURFACE OF GLASS LAYER — PROCESS 70

↓

APPLYING THIRD ADHESIVE PORTION OF SECOND ADHESIVE LAYER TO ONE SURFACE OF GLASS LAYER — PROCESS 80

↓

CURING — PROCESS 90

↓

LOWERING TEMPERATURE — PROCESS 100

FIG. 9

| INTERNATIONAL SEARCH REPORT | International application No. |
|---|---|
| | **PCT/KR2023/009503** |

**A.     CLASSIFICATION OF SUBJECT MATTER**

**G09F 9/30**(2006.01)i; **G06F 1/16**(2006.01)i; **H04M 1/02**(2006.01)i; **G09F 9/33**(2006.01)i

According to International Patent Classification (IPC) or to both national classification and IPC

**B.     FIELDS SEARCHED**

Minimum documentation searched (classification system followed by classification symbols)

G09F 9/30(2006.01); B32B 7/00(2006.01); C08K 5/00(2006.01); C08L 75/16(2006.01); C09J 9/00(2006.01); F16C 11/04(2006.01); G06F 1/16(2006.01); G06F 11/30(2006.01); H05K 3/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 플렉서블(flexible), 디스플레이(display), 접착(adhesion), 영률(young's modulus), 열팽창률(thermal expansivity)

**C.     DOCUMENTS CONSIDERED TO BE RELEVANT**

| Category* | Citation of document, with indication, where appropriate, of the relevant passages | Relevant to claim No. |
|---|---|---|
| Y | KR 10-2021-0034480 A (SAMSUNG ELECTRONICS CO., LTD.) 30 March 2021 (2021-03-30) See paragraphs [0029]-[0287] and figures 1-21. | 1-8,10-15 |
| A | | 9 |
| Y | KR 10-2020-0101220 A (SAMSUNG ELECTRONICS CO., LTD.) 27 August 2020 (2020-08-27) See paragraph [0078] and figure 5a. | 1-8,10-15 |
| Y | KR 10-2022-0067458 A (SAMSUNG ELECTRONICS CO., LTD.) 24 May 2022 (2022-05-24) See paragraphs [0101]-[0145]. | 3,10-13 |
| Y | KR 10-1517263 B1 (ARIZONA BOARD OF REGENTS, A BODY CORPORATE OF THE STATE OF ARIZONA, ACTING FOR AND ON BEHALF OF ARIZONA STATE) 30 April 2015 (2015-04-30) See paragraphs [0020]-[0039]. | 8 |

☑ Further documents are listed in the continuation of Box C.     ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **17 October 2023** | **17 October 2023** |

| Name and mailing address of the ISA/KR | Authorized officer |
|---|---|
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
| --- |
| **PCT/KR2023/009503** |

**C.     DOCUMENTS CONSIDERED TO BE RELEVANT**

| Category* | Citation of document, with indication, where appropriate, of the relevant passages | Relevant to claim No. |
| --- | --- | --- |
| A | US 2021-0108077 A1 (CORNING INCORPORATED) 15 April 2021 (2021-04-15)<br>    See claims 337-352. | 1-15 |

Form PCT/ISA/210 (second sheet) (July 2022)

**INTERNATIONAL SEARCH REPORT**
Information on patent family members

International application No.

**PCT/KR2023/009503**

| Patent document cited in search report | | | Publication date (day/month/year) | Patent family member(s) | | | Publication date (day/month/year) |
|---|---|---|---|---|---|---|---|
| KR | 10-2021-0034480 | A | 30 March 2021 | CN | 114424272 | A | 29 April 2022 |
| | | | | EP | 3997689 | A1 | 18 May 2022 |
| | | | | US | 2021-0092855 | A1 | 25 March 2021 |
| | | | | WO | 2021-054759 | A1 | 25 March 2021 |
| KR | 10-2020-0101220 | A | 27 August 2020 | CN | 113454566 | A | 28 September 2021 |
| | | | | EP | 3907581 | A1 | 10 November 2021 |
| | | | | EP | 3907581 | B1 | 05 April 2023 |
| | | | | EP | 4209863 | A1 | 12 July 2023 |
| | | | | US | 2022-0141969 | A1 | 05 May 2022 |
| | | | | WO | 2020-171562 | A1 | 27 August 2020 |
| KR | 10-2022-0067458 | A | 24 May 2022 | WO | 2022-108198 | A1 | 27 May 2022 |
| KR | 10-1517263 | B1 | 30 April 2015 | CN | 101980861 | A | 23 February 2011 |
| | | | | CN | 101980861 | B | 06 August 2014 |
| | | | | EP | 2274162 | A1 | 19 January 2011 |
| | | | | JP | 2011-520248 | A | 14 July 2011 |
| | | | | JP | 5555226 | B2 | 23 July 2014 |
| | | | | US | 2011-0064953 | A1 | 17 March 2011 |
| | | | | US | 8685201 | B2 | 01 April 2014 |
| | | | | WO | 2009-126544 | A1 | 15 October 2009 |
| US | 2021-0108077 | A1 | 15 April 2021 | CN | 114829444 | A | 29 July 2022 |
| | | | | EP | 4045558 | A1 | 24 August 2022 |
| | | | | JP | 2022-552367 | A | 15 December 2022 |
| | | | | KR | 10-2022-0084313 | A | 21 June 2022 |
| | | | | WO | 2021-076434 | A1 | 22 April 2021 |

Form PCT/ISA/210 (patent family annex) (July 2022)